# EUROPEAN PATENT APPLICATION

(11) **EP 0 814 498 A1**
(43) Date of publication of application: **29.12.1997**
(21) Application number: 97108728.3
(22) Date of filing: 30.05.1997
(51) Int. Cl.: H01L 21/3205, H01L 27/108, H01L 21/8242

(54) **Capacitor and its manufacturing process**

(30) Priority: 31.05.1996 US 18767 P
(71) Applicant: TEXAS INSTRUMENTS INCORPORATED, Dallas Texas 75265 (US)
(72) Inventor: McKee, Jeff, Grapevine, Texas 76051 (US); McAnally, Peter S., McKinney, Texas 75070 (US); Crenshaw, Darius L., Plano, Texas 75075 (US); Taylor, Kelly J., Plano, Texas 75075 (US); Anderson, Dirk N., Plano, Texas 75075 (US)
(74) Representative: Schwepfinger, Karl-Heinz, Dipl.-Ing.

(57) **Abstract**

A capacitor and method of forming the capacitor for high density applications. A polysilicon base layer (116) is deposited. Then, alternating layers of a first (130) and second (132) material having different etch selectivities are deposited. The alternating layers (130,132) are patterned and anisotropically etched. A selective etch is then used to radially etch the first material layers (130) such that the first material layers (130) undercut the second material layers (132). A conformal layer of polysilicon (136) is then deposited over the structure including in the undercut areas (138). The alternating layers are then removed leaving the conformal layer of polysilicon (136) having increased surface area to serve as the storage node of the capacitor.

## Description

### FIELD OF THE INVENTION

The present invention generally relates to integrated circuits, and more particularly to a capacitor structure for high density integrated circuit devices.

### BACKGROUND OF THE INVENTION

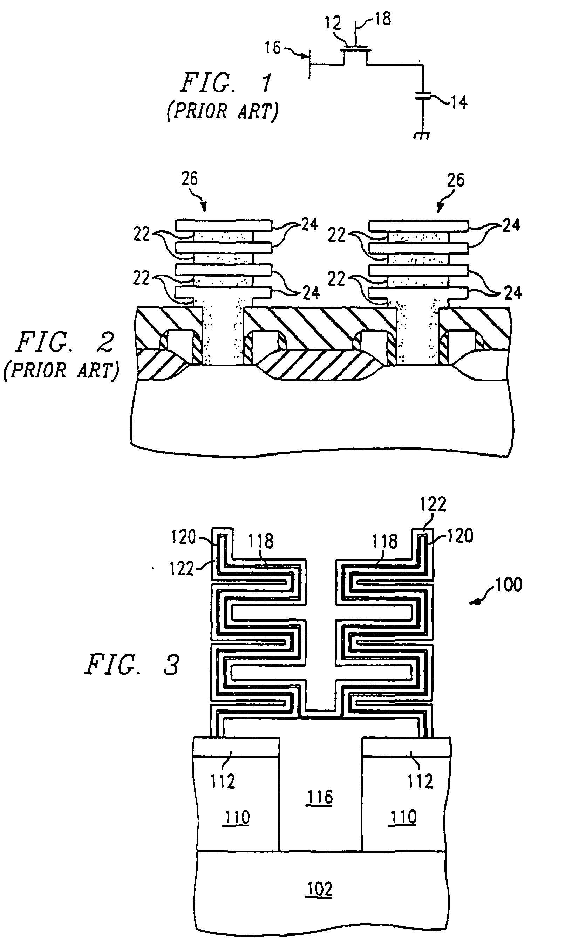

One common high density memory is the Dynamic random access memory (DRAM). DRAMs comprise an array of individual cells for storing information. These cells are dynamic in that they will only hold a bit of information for a short period of time. Therefore, the cells must be read and refreshed at periodic intervals. The most common cell configuration consists of one transistor 12 and one capacitor 14 as shown in Figure 1. The transistor 12 is a pass transistor and is connected between a bitline 16 and the capacitor 14. The pass transistor 12 is gated by a wordline signal 18. A bit of information is stored on the capacitor 14 and is read from the cell to the associated bitline or written to the cell from the bitline through pass transistor 12.

As the density of the memory devices increases, it becomes more difficult to achieve sufficient cell capacitance in the smaller area allotted for each cell. One prior art method deposits alternating layers of in-situ doped polysilicon 22 and undoped polysilicon 24. The doped and undoped polysilicon (22,24) have different etch rates. Thus, they may be etched to form a bellows shaped storage node 26 of a capacitor as shown in Figure 2. This structure has increased surface area and thus increased capacitance for a given cell area of a device. However, it suffers low throughput due to the deposition of doped and undoped polysilicon layers using different deposition tools. Therefore, there is a need for a process having more margin, higher throughput, and/or that is a simplification over the prior art.

### SUMMARY OF THE INVENTION

Therefore, a need has arisen for a method of fabricating a DRAM cell that reduces the problems associated with previous capacitor structures, while maintaining sufficient storage capacity for the capacitor.

According to the teachings of the present invention a method for forming a capacitor is provided. The method comprises the steps of: depositing a first film and depositing a second film over the first film. The steps of depositing the first film and the second film are repeated at least one time to form a plurality of first film layers alternated with a plurality of second film layers.

The alternating plurality of first film layers and second film layers are then patterned and etched, before being selectively etched in order that the plurality of first film layers are undercut from said plurality of second film layers to form undercut regions. A conformal layer of conductive material is then deposited over the plurality of first and second film layers including the undercut regions before the conformal layer of conductive material is etched back.

The plurality of first and second film layers are then selectively removed such that the conformal layer of conductive material remains. A dielectric is then formed over the conformal layer of conductive material before a conductive tap node is formed over the dielectric.

Preferably, the first film is formed from a material having an etch selectively less than the etch selectivity of the material of the second film. This aids the selective etching of the first and second films to form the undercut regions.

### BRIEF DESCRIPTION OF THE DRAWINGS

The present invention will now be further described, by way of example, with reference to the accompanying drawings in which:
FIG. 1 is a schematic diagram of a prior art DRAM cell;
FIG. 2 is a cross-sectional view of a prior art DRAM capacitor;
FIG. 3 is a cross-sectional view of a capacitor according to a first embodiment of the invention;
FIG. 4 is a cross-sectional view of a pair of DRAM cells prior to the formation of a storage node;
FIGs. 5-12b are cross-sectional views of the capacitor according to the first embodiment of the invention at various stages of fabrication;
FIGs. 13-17b are cross-sectional views of a capacitor according to a second embodiment of the invention at various stages of fabrication;
FIG. 18 is a cross-sectional view of a planarized capacitor array according to a third embodiment of the invention; and
FIGs. 19-20 are cross-sectional view of the planarized capacitor array of FIG. 18 are various stages of fabrication.

Corresponding numerals and symbols in the different figures refer to corresponding parts unless otherwise indicated.

### DETAILED DESCRIPTION OF PREFERRED EMBODIMENTS

The invention will now be described in conjunction with a capacitor-over-bitline type DRAM cell. Those of ordinary skill in the art of high density devices such as DRAMs will recognize that the capacitor of the invention may also be used in conjunction with other types of DRAM cells as well as other high density applications.

A capacitor 100 according to a first embodiment of the invention is shown in Figure 3. Capacitor 100 contacts substrate 102 through an interlevel dielectric layer comprising, for example, an oxide layer 110 and a nitride layer 112. The bottom node of capacitor 100 comprises a polysilicon layer 116 and a corrugated-cylinder-shaped polysilicon structure 118 both preferably comprising doped polysilicon. However, other conductive materials may alternatively be used. A capacitor dielectric separates 120 the bottom node (116,118) of capacitor 100 from the top node 122. The capacitor dielectric 120 may, for example, comprise a nitride-oxide bilayer and the top node 122 preferably comprises doped polysilicon. However, other conductive materials may alternatively be used. The shape of the polysilicon structure 118 provides a significant increase in surface area of the bottom node (116, 118) and a corresponding increase in capacitance. For example, an increase in surface area on the order of 3.5X can be obtained.

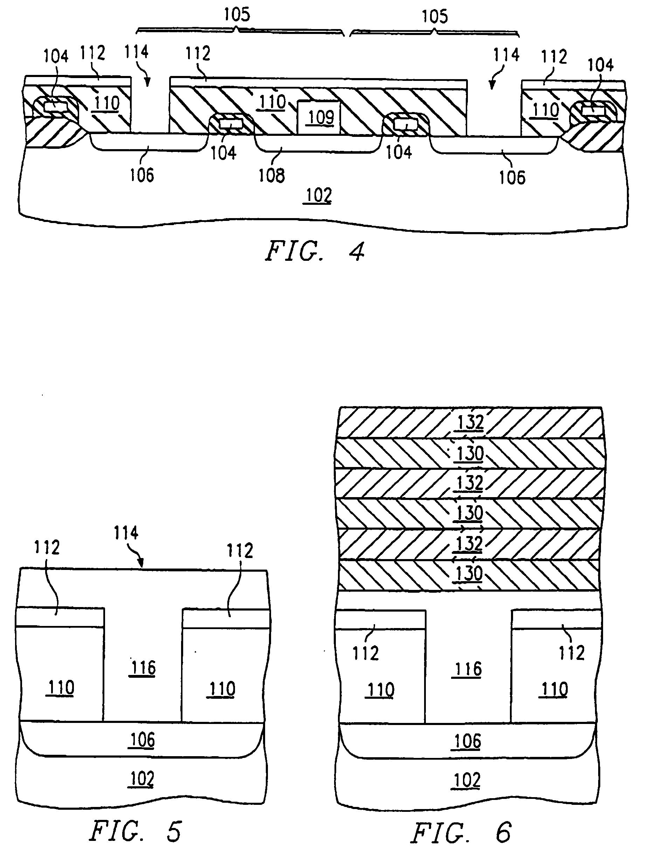

Figure 4 illustrates a pair of DRAM cells prior to the formation of a storage capacitor. Wordlines 104 form the gates of transistors 105 Source/drain regions 106 and 108 are formed on opposites sides of wordlines 104. Bitline/bitline contact 109 contacts source/drain region 108. Subsequently formed storage capacitors will connect to source/drain regions 106 through interlevel dielectric 110/112. Those skilled in the art will realize that the capacitor according to the invention may be used in conjunction with many other known methods for forming DRAM cells.

A method of forming the capacitor 100 according to the invention into the structure of Figure 4 will now be described. First, a layer of polysilicon 116 is deposited over nitride layer 112 and in storage node contact area 114, as shown in Figure 5. If the formation of a nitride layer 112 is not already part of the process, it should be added prior to the etch forming storage node contact area 114. Polysilicon 116 may directly contact source/drain region 106 or a plug (not shown) may be used in storage node contact area 114 to connect polysilicon 116 to source/drain region 106. Polysilicon layer 116 is preferably insitu doped and deposited to a thickness of the order of 200 to 1500 Angstroms.

Next, alternating layers (130 and 132) of a first material (130) and a second material (132) are deposited, as shown in Figure 6. The first and second materials have vastly different selectivities in an etch process. For example, the second material layers 132 could comprise TEOS (tetraethoxysilane derived silicon oxides) and the first material layers 130 could comprise an SACVD (sub-atmospheric chemical-vapor deposition) oxide or PSG (phosphosilicate glass). Various combinations of first and second materials will be apparent to those skilled in the art. For example, combinations of doped and undoped oxides or hard and soft oxides could be used. However, it should be noted that the first and second materials should also be capable of being etched selectively with respect to polysilicon. An etch selectivity ratio on the order of 20:1 or greater is desirable. However, selectivities as low as 5:1 may also be used.

The thickness of alternating layers 130 and 132 may be of the order of 150-500 Angstroms. Although shown as the same thickness, it should be noted that layers 130 and 132 need not be of the same thickness. The thickness is a design variable chosen on the basis of, for example, desired surface area and the area required for the subsequent steps of forming the capacitor dielectric and top node of the capacitor. The number of alternating layers 130,132 may also vary depending of the surface area desired and mechanical stability/reliability of the resulting structure. At least two of each layer 130, 132 should be used.

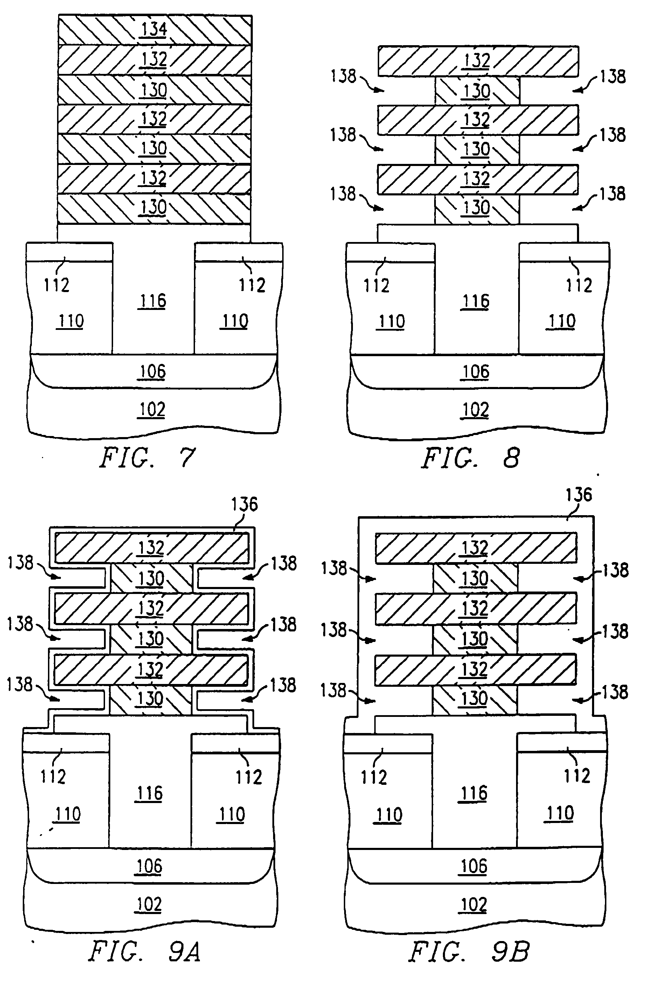

As shown in Figure 7, the structure is patterned, for example using a layer of resist 134, and anisotropically etched. The etch of polysilicon layer 116 is optional at this point and may be delayed until later in the process to limit the number of polysilicon etches. Resist layer 134 is then removed.

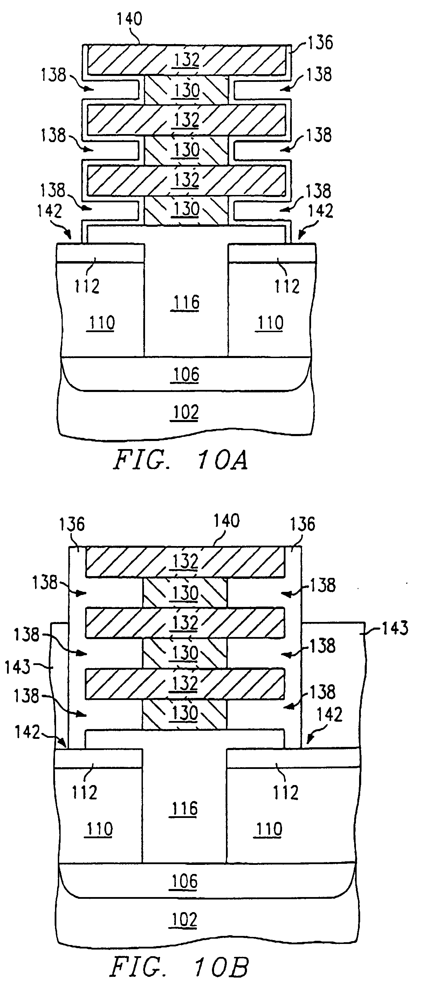

The layers of first material 130 are then selectively etched with respect to the layers of second material 132, as shown in Figure 8. The first material layers 130 are etched radially to undercut the first material layers 130 from the second material layers 132. The etch chemistry and type may vary depending on the composition of the first and second materials. For example, if 11% PSG and TEOS are used, respectively, a 1% unbuffered HF etch may be used for a duration of the order of 35-40 sec. The duration of the etch is determined by the extent of the undercut desired. Other appropriate etches, such as an appropriate vapor HF etch or an isotropic plasma etch, will be apparent to those of ordinary skill in the art having reference to the specification. If polysilicon layer 116 has been previously etched, nitride layer 112 prevents oxide layer 110 from being affected during this etch. However, even if this nitride layer were absent, a negligible amount of the appropriate interlevel dielectric comprising the top surface of material 110 should be consumed in such a dilute HF etch.

Using a process that allows for the minimum growth of native oxide on polysilicon, a thin conformal layer of polysilicon 136 is deposited on the structure including the undercut areas 138. For example, an insitu vapor HF unit on a polysilicon deposition cluster tool may be used. Alternatively, a 400 C push insitu-doped polysilicon deposition immediately after the selective first material etch may be used. Other etches will be apparent to those of ordinary skill in the art having reference to the specification. It should be noted that although polysilicon is conventionally used to form the capacitor, other conductive materials may be used in place of polysilicon.

The polysilicon layer 136 is deposited to a thickness of the order of 100-700 angstroms and is preferably doped. The thickness of polysilicon layer 136 depends on the thicknesses of the first and second material layers (130,132). The thickness of the first material layers 130 is the most critical. If the thickness of polysilicon layer 136 is less than one-half of the thickness of the first material layers 130, then the structure shown in Figure 9a is obtained. If the thickness of polysilicon layer 136 is greater than one half the thickness of first material layers 130, the structure of Figure 9b is obtained. In the preferred embodiment, the polysilicon layer 136 should have a thickness of on the order of 200 Angstroms and no more than 2000 Angstroms. It should be noted that for the structure of Figure 9a, the polysilicon layer 136 thickness should be less than half the thickness of the first material layers by an amount sufficient to allow a capacitor dielectric and top capacitor node to be formed within the undercut areas 138.

As shown in Figures 10a-b, a polysilicon etch-back is performed next. This removes polysilicon from the top surface 140 of the storage node and from the area between storage nodes 142. The portions of polysilicon layer 136 on the sides of the structure and in the undercut areas 138 remain after the etch-back. It should be noted that if polysilicon layer 136 was deposited undoped, it may be doped prior to the etchback. Prior to the polysilicon etchback, an optional thin layer of rugged polysilicon may be deposited over polysilicon layers 116 and 136. This allows for further surface area enhancement. Methods for depositing rugged polysilicon to further enhance the surface area are well known in the art.

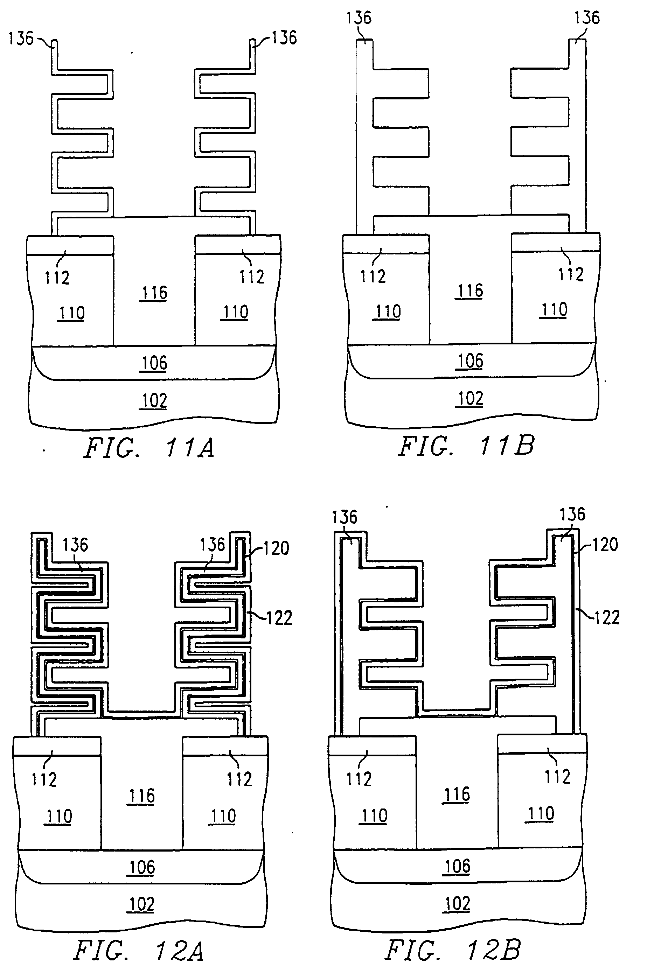

Next, the layers of first and second material (130,132) are removed. If desired, a resist layer 143 can be spin deposited and etched back prior to the removal of the first and second materials (130,132) in order to protect the oxide regions between the storage nodes. Preferably, an isotropic (wet or plasma) etch is used to remove the layers of first and second material (130,132) to ensure the complete removal of these layers. The etch is selective against etching polysilicon. Polysilicon layer 136 remains intact as shown in Figures 11a-b.

The structure is completed by forming the capacitor dielectric 120, for example and a nitride/oxide bilayer, and a top node 122 of the storage capacitor 100. The top node 122 of the storage capacitor 100 preferably comprises doped polysilicon. The completed structure is shown in Figures 12a-b. The structure of Figure 12a yields more surface area, whereas the structure of Figure 12b is more robust and manufacturable.

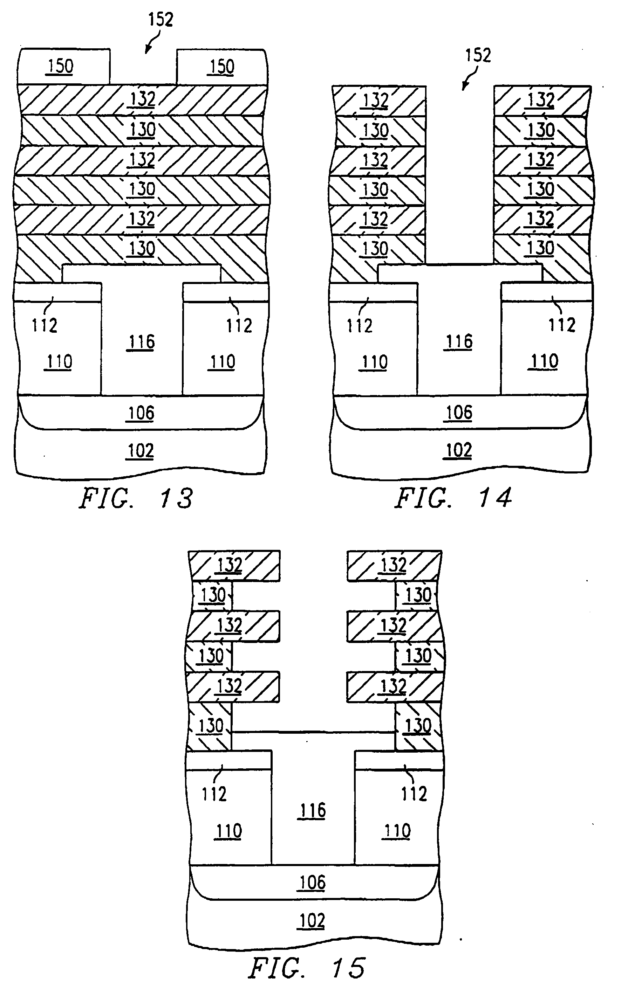

A method of forming a second embodiment of the invention will now be described. The second embodiment is a mirror image of the first embodiment and may be preferred due to higher mechanical stability. The polysilicon layer 116 and alternating layers of first and second material 130,132 are deposited as in the first embodiment. However, the polysilicon pad layer 116 may be patterned and etched at this point with a store pattern. This eliminates the need to etch this layer later on in the process. These layers are then patterned using masking layer 150 as shown in Figure 13. An area 152 in the center of where the storage node will be is exposed. This area may be of the order of one quarter to one third the width of the final structure. A hard mask with a sidewall spacer may be required in order to obtain a hole smaller in diameter than the minimum critical dimension (CD). For example, for a minimum capacitor width of 2600 Angstroms, area 152 may be of the order of 1000 Angstroms. An anisotropic etch is then performed to remove layers 130 and 132 below area 152 as shown in Figure 14.

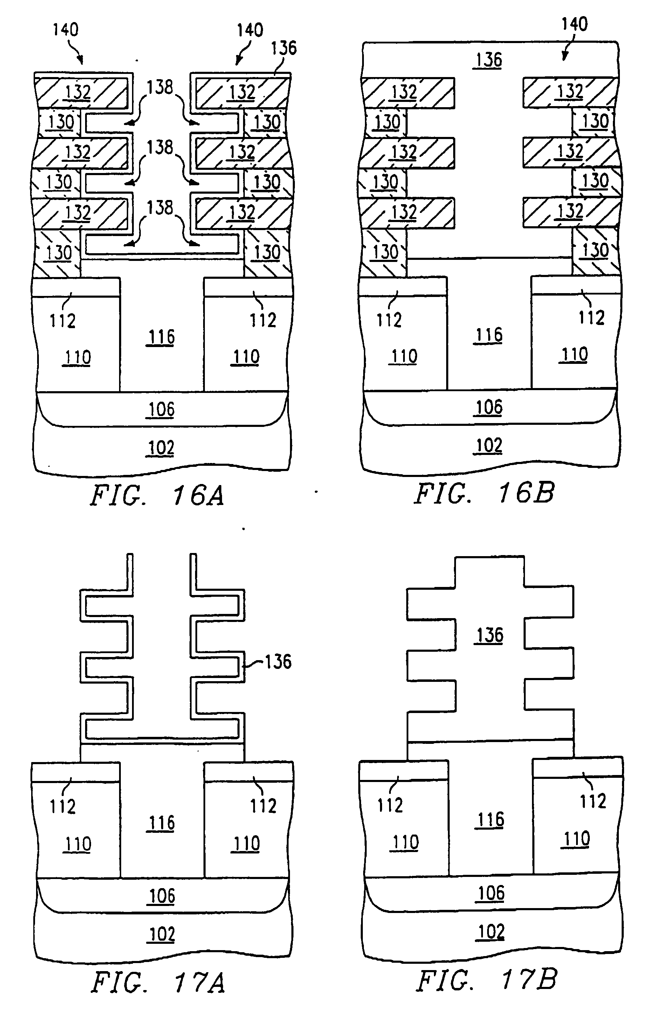

Next, a selective etch is performed to etch the first material layers 130 selectively with respect to the second material layers 132. The first material layers 130 are etched radially to undercut the first material layers 130 from the second material layers 132, as shown in Figure 15. As with the first embodiment, the etch chemistry and type may vary depending on the composition of the first and second materials. For example, if PSG and TEOS are used, respectively, a 1% unbuffered HF may be used for a duration on the order of 35-40 sec.. The duration of the etch is determined by the extent of the undercut desired. Other appropriate etches, such as an appropriate vapor HF etch or an isotropic plasma etch, will be apparent to those of ordinary skill in the art having reference to the specification.

Using a process that allows for the minimum growth of native oxide on polysilicon, a thin conformal layer of polysilicon 136 is deposited on the structure including the undercut areas 138, as in the first embodiment. The polysilicon layer 136 may be deposited to a thickness of the order of 1000 angstroms and is preferably doped. As in the first embodiment, the thickness of polysilicon layer 136 depends on the thicknesses of the first and second material layers (130,132). If the thickness of polysilicon layer 136 is less than one-half of the thickness of the first material layers 130, then the structure shown in Figure 16a is obtained. If the thickness of polysilicon layer 136 is greater than one half the thickness of first material layers 130, the structure of Figure 16b is obtained.

An optional thin layer of rugged polysilicon may be deposited over polysilicon layers 116 and 136. This allows for further surface area enhancement. Methods for depositing rugged polysilicon to further enhance the surface area are well known in the art. A polysilicon etch-back is performed next. This removes polysilicon from the top surface 140 of the storage node. The portions of polysilicon layer 136 on the sides of the structure and in the undercut areas 138 remain after the etch-back. It should be noted that if polysilicon layer 136 was deposited undoped, it may be doped prior to the etchback.

Next, the layers of first and second material (130,132) are removed. Preferably, an isotropic (wet or plasma) etch is used to ensure the complete removal of these layers. The etch is selective against etching polysilicon. Polysilicon layer 136 remains intact as shown in Figures 17a-b. The portion of polysilicon layer 116 between storage nodes is removed at this point if it has not been removed previously.

The structure is completed by forming a capacitor dielectric and a top node the storage capacitor, similar to that described above with respect to the first embodiment. The top node of the storage capacitor preferably comprises doped polysilicon. The capacitor dielectric may, for example, comprise a nitride/oxide bilayer. The structure of Figure 17a yields more surface area, whereas the structure of Figure 17b is more robust and manufacturable.

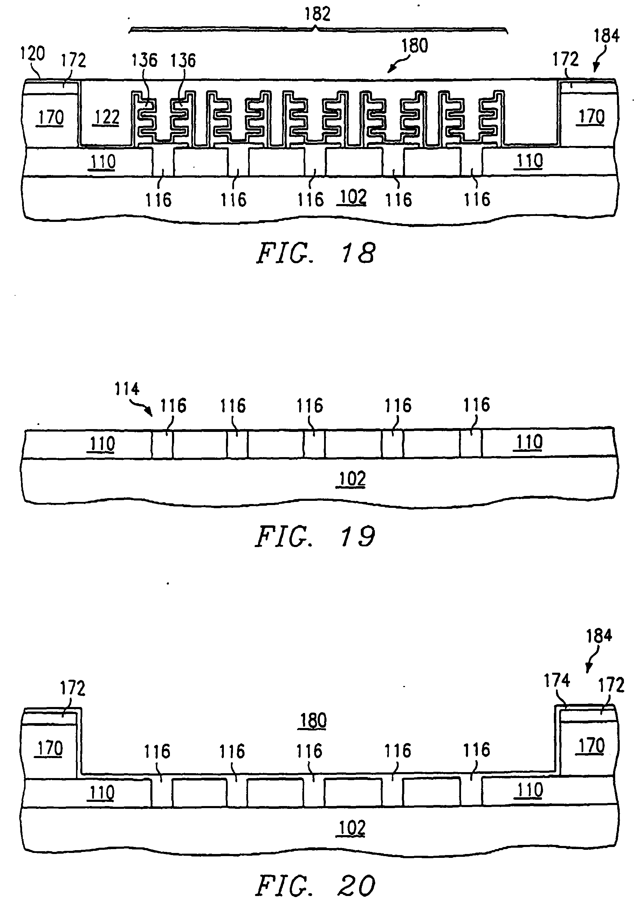

A planarized capacitor array 182 according to a third embodiment of the invention is shown in Figure 18. The capacitor structures of capacitor array 182 are illustrated similar to that of the first embodiment. However, the planarized structure and method of the third embodiment may also be applied to other capacitor over bitline structures known in the art. Capacitor array 182 is located within a storage plate cavity 180. Storage plate cavity 180 is bounded by a planarizing structure that includes a dielectric portion 170 and a dielectric mask portion 172. Dielectric portion 170 may, for example, be an oxide such as borophosphosilicate glass, BPSG and the dielectric mask portion 172 may, for example, comprise silicon nitride. The height of dielectric portions 170 and 172 combined is approximately equal to the height of the final capacitor structures of capacitor array 182. Planarizing structure (170,172) avoids the traditional step height difference between the area of the device containing the capacitor array and the peripheral region. The step height difference increases as density of the array increases. For example, in a 256 Meg DRAM, the step height difference may be on the order of 500 nm. The step height difference creates significant problems in forming the subsequent interconnect levels because these interconnect levels must transition between the peripheral area and the capacitor array area. Including planarizing structure (170,172) avoids this problem and provides a low-cost substitute for chemical-mechanical planarization.

A method of forming the capacitor array according to the third embodiment of the invention into the structure of Figure 4 will now be discussed. First, polysilicon plugs 116 are formed within storage node contact area 114 and no nitride layer 112 is needed, as shown in Figure 19. The structure of Figure 19 is planarized. Next, a layer of dielectric material 170 is deposited over the structure. Dielectric material 170 preferably comprises an oxide such as BPSG. A layer of nitride 172 is then deposited over the oxide layer 170. The thicknesses of oxide layer 170 and nitride layer 172 are chosen such that the combined height of the two layers is approximately equal the desired height of the final capacitor structure. For example, this may be on the order of 500 nm. Nitride layer 172 and oxide layer 170 are then patterned and etched to form storage plate cavity 180 bounded by a planarizing structure 184, as shown in Figure 20. Planarizing structure 184 consists of the remaining portions of oxide layer 170 and nitride layer 172. Nitride layer 172 serves as a masking layer in subsequent processing steps to protect oxide layer 170.

A layer of polysilicon 174, preferably in situ doped, is then deposited over nitride layer 172 and in storage plate cavity 180. Polysilicon layer 174 may be of the order of 50 nm. Polysilicon layer 174 protects the vertical edges of oxide layer 170 and the surface of interlevel dielectric layer 110 during subsequent processing steps. Processing then continues to form the capacitor array 182. Capacitor array 182 may be formed as described above with respect to the first or second embodiments beginning with the deposition of the alternating oxide layers 130 and 132. In this case, alternating layers of first material (130) and second material (132) are deposited to a total thickness approximately equal to the depth of storage plate cavity 180 (i.e., within a thickness equal to the thickness of layer 130 or layer 132). Non-critical resist patterning steps may be required in lieu of CMP. Preferably, a spacing approximately equal to the depth of the storage plate cavity is left between the edges of the capacitor array 182 and the planarizing structure 184 to ensure that the uniform quality of the alternating layers 130,132 is maintained at the edges of capacitor array 182. This provision only minimally increases the size of the overall device (i.e., adds approximately 1 micron to a device size in the millimeter range). Alternatively, other capacitor structures known in the art may also be used. After depositing the top electrode material 122, the top electrode material, typically polysilicon, is then etched back or otherwise removed to be co-planar with the height of planarizing structure 184 as shown in Figure 18. This results in a planarized structure that avoids the step height and associated problems found in the prior art.

While this invention has been described with reference to illustrative embodiments, this description is not intended to be construed in a limiting sense. Various modifications and combinations of the illustrative embodiments, such as choosing the first and second materials such that the second material etches faster than the first material, as well as other embodiments of the invention, will be apparent to persons skilled in the art upon reference to the description.

## Claims

1. A method for forming a capacitor comprising the steps of:
depositing a first film;
depositing a second film over said first film;
repeating said steps of depositing said first film and depositing said second film to form a plurality of first film layers alternated with a plurality of second film layers;
patterning and etching said plurality of first and second film layers;
selectively etching said plurality of first and second film layers, such that the plurality of first film layers are undercut from said plurality of second film layers to form undercut regions;
depositing a conformal layer of conductive material over said plurality of first and second film layers including in said undercut regions;
etching back said conformal layer of conductive material;
selectively removing said plurality of first and second film layers without removing said conformal layer of conductive material; and
forming a capacitor dielectric over said conformal layer of conductive material.

2. The method of Claim 1 further comprising forming a top node over said dielectric.

3. The method of Claim 1 or Claim 2, wherein said step of depositing said second film comprises depositing a material comprising tetraethoxysilane-derived silicon oxides (TEOS).

4. The method of any preceding claim, wherein said step of depositing said first film comprises depositing a material comprising phosphosilicate glass.

5. The method of any preceding claim, wherein said step of depositing said first film comprises depositing a material comprising a SACVD oxide.

6. The method of any preceding claim, wherein said step of depositing said conformal layer of conductive material comprises depositing said layer of conformal material to a thickness greater than one half a thickness of said first film.

7. The method of any of Claims 1 to 5, wherein said step of depositing said conformal layer of conductive material comprises depositing said layer of conformal material to a thickness less than one half a thickness of said first film.

8. The method of any preceding claim further comprising the steps of:
forming a contact area; and
depositing a base layer of conductive material in and around said contact area prior to said step of depositing said first film.

9. The method of Claim 8, wherein said patterning and etching step comprises masking an area overlying said contact area.

10. The method of Claim 8, wherein said patterning and etching step comprises exposing an area overlying said contact area.

11. The method of any preceding claim, further comprising the steps of:
depositing a layer of rugged polysilicon over said conformal layer of conductive material after said step of depositing said conformal layer of conductive material.

12. The method of any preceding claim, wherein said step of depositing said conformal layer of conductive material comprises depositing a material comprising polysilicon.

13. A method of forming a capacitor comprising the steps of:
forming a contact area;
depositing a first layer of polysilicon in and around said contact area;
depositing a plurality of alternating layers of a first material and a second material over said first polysilicon layer;
patterning said plurality of alternating layers to expose a first region;
anisotropically etching said plurality of alternating layers in said first region to expose said first layer of polysilicon;
selectively and radially etching said plurality of alternating layers of said first material and said second material such that the plurality of layers of said first material are undercut from said plurality of layers of said second material to form under cut regions;
depositing a second layer of polysilicon over said plurality of alternating layers;
etching back said second layer of polysilicon to expose a top surface of said plurality of alternating layers;
selectively removing said plurality of alternating layers without removing said second layer of polysilicon; and
forming a dielectric over said second layer of polysilicon.

14. The method of Claim 13 further comprising;
forming a conductive top node over said dielectric.

15. the method of Claim 13 or Claim 14, wherein the step of depositing alternating layers comprises depositing alternating layers of a fist material and a second material having different etch selectivities in a ratio of at least 5:1.

16. The method of any of Claims 13 to 15, wherein said step of depositing said second material comprises depositing a material comprising tetraethoxysilane-derived silicon oxides (TEOS).

17. The method of any of Claims 13 to 16, wherein said step of depositing said first material comprises depositing a material comprising phosphosilicate glass.

18. The method of any of Claims 13 to 17, wherein said step of depositing said first material comprises depositing a material comprising SACVD oxide.

19. The method of any of Claims 13 to 18, wherein said step of depositing said second layer of polysilicon comprises depositing said second layer of polysilicon to a thickness greater than one half a thickness of ones of said plurality of alternating layers comprising said first material.

20. The method of any of Claims 13 to 18, wherein said step of depositing said second layer of polysilicon comprises depositing said second layer of polysilicon to a thickness less than one half a thickness of ones of said plurality of alternating layers comprising said first material.

21. The method of any of Claims 13 to 20 further comprising the step of depositing a layer of polysilicon over said second layer of polysilicon prior to said step of performing an etch-back of said second layer of polysilicon.

22. The method of any of Claims 13 to 21 further comprising the step of patterning and etching said first layer of polysilicon using a store pattern prior to said step of depositing a plurality of alternating layers of first and second material.

23. The method of any of Claims 13 to 22, wherein said step of patterning said plurality of alternating layers comprises the steps of:
forming a hard mask; and
forming a sidewall on said hard mask to form a sublithographic hole pattern.
